Europäisches Patentamt

European Patent Office

Office européen des brevets

(19)

(11) EP 1 298 461 A1

(12) EUROPEAN PATENT APPLICATION

(43) Date of publication:
02.04.2003 Bulletin 2003/14

(51) Int Cl.7: G02B 6/12, H01L 33/00, H01S 5/183, H01L 31/0203

(21) Application number: 01203678.6

(22) Date of filing: 27.09.2001

(84) Designated Contracting States:
AT BE CH CY DE DK ES FI FR GB GR IE IT LI LU MC NL PT SE TR
Designated Extension States:
AL LT LV MK RO SI

(71) Applicants:
• INTERUNIVERSITAIR MICROELEKTRONICA CENTRUM VZW
3001 Leuven (BE)
• Umicore
1000 Brussels (BE)
• UNIVERSITEIT GENT
9000 Gent (BE)

(72) Inventors:
• Modak, Prasanta
Champain, Illinois 61821 (US)
• Moerman, Ingrid
9810 Nazareth (BE)
• D'Hondt, Marc
9960 Assenede (BE)

(74) Representative: Bird, William Edward et al
Bird Goen & Co.,
Klein Dalenstraat 42A
3020 Winksele (BE)

(54) **Distributed Bragg reflector comprising GaP and a semiconductor resonant cavity device comprising such DBR**

(57) The present invention relates to a special type of Distributed Bragg Reflectors (DBRs). The present invention also relates to semiconductor semiconductor resonant cavity devices for emitting or absorbing light.

A DBR for reflecting radiation with a wavelength $\lambda$, according to the present invention, includes at least one mirror pair. Each mirror pair comprises a bottom layer and a top layer, the top layer of one mirror pair comprising gallium phosphide (GaP) and having an optical thickness of substantially an odd multiple of $\lambda/4$.

A resonant cavity device (40) for emitting or absorbing light with a wavelength $\lambda$, according to the present invention, comprises a first mirror (44) and a second mirror (68) with an active region (54) located therebetween. The second mirror (68) comprises a stack of DBRs including at least one mirror pair (69, 70), the mirror pair (69, 70) having at least a top layer (70) and a bottom layer. The top layer (70) is the layer most remote from the first mirror (44), and this layer is essentially composed of gallium phosphide (GaP) and has an optical thickness of substantially an odd multiple of $\lambda/4$.

The present invention also provides a method of manufacturing a resonant cavity device for emitting or absorbing light with a wavelength $\lambda$.

Fig. 5

EP 1 298 461 A1

## Description

## Technical field of the invention

The present invention relates to a special type of Distributed Bragg Reflectors (DBRs).

The present invention also relates to semiconductor resonant cavity devices for emitting or absorbing light, such as semiconductor light emitting diodes, lasers and resonant detectors, and, more particularly, to resonant cavity light-emitting diodes (RCLEDs), also known as microcavity light-emitting diodes (MCLEDs), comprising such a special type of DBR.

## Background of the invention

Emission in the visible wavelength is useful for car tail and brake lights, traffic lights, full colour LED displays, scanners, printers, high definition television and for short-haul optical fibre communication, which has a low absorption at 650 nm. The optical output power that could be extracted out of a conventional light emitting diode is limited to 2% because of total internal reflection at the semiconductor-air interface. This limits the use of a conventional LED.

Recently, there has been an increased interest in RCLEDs, and specifically red emitting RCLEDs based on indium aluminium gallium phosphide (In-AlGaP) material.

The working principle of an RCLED is based on a Fabry-Perot resonance, an active region placed inside a cavity formed by two parallel reflective mirrors. The mirrors are typically quarter-wave ($\lambda$/4) semiconductor or dielectric distributed Bragg reflectors (DBRs). For an RCLED, one DBR has a reflectance (R) of near 100% at the Bragg wavelength, while the other DBR has a lower reflectance, preferably R < 90%. That way, light is emitted from the RCLED at the side of the mirror with the lowest reflectance.

An RCLED structure is for example described in P. Modak et al., "5.2% efficiency InAlGaP microcavity LEDs at 640 nm on Ge substrates", Electronics Letters, 15th March 2001, Vol. 37 No.6, and in P. Modak et al., "InAlGaP microcavity LEDs on Ge-substrates", Journal of Crystal growth 221 (2000), pp.668-673. A stack of bottom DBR mirrors having a plurality of alternating layers with alternating refractive indexes, is grown on a substrate. For a 638 nm emitting RCLED, this stack of bottom DBR mirrors e.g. is a 26.5 period DBR, comprising alternating layers of silicon-doped aluminium gallium arsenide ($Al_{0.55}Ga_{0.45}As$), 45.7 nm thick, and aluminium arsenide (AlAs), 51.6 nm thick, so that all layers have an optical thickness of one quarter wavelength. An active region placed in a cavity, surrounded by spacer layers, is provided on top of the stack of bottom DBR mirrors. The spacer layers may for example be aluminium gallium indium phosphide (($Al_{0.7}Ga_{0.3})_{0.52}In_{0.48}P$), 86.6 nm thick. The active region may for example be three 6 nm thick ($Al_{0.1}Ga_{0.9})_{0.43}In_{0.57}P$ quantum wells embedded in ($Al_{0.7}Ga_{0.3})_{0.52}In_{0.48}P$ barrier material. On top of the cavity, a stack of top DBR mirrors is again provided, having a plurality of alternating layers with alternating refractive indexes. This stack of top DBR mirrors e.g. is a 5 period DBR, comprising alternating layers of zinc-doped $Al_{0.95}Ga_{0.05}As$, 50.9 nm thick, and $Al_{0.55}Ga_{0.45}As$, 45.7 nm thick. To improve current spreading, a 3 µm thick $Al_{0.55}Ga_{0.45}As$ layer is grown on top of the top DBR mirror, followed by a 10 nm highly p-doped gallium arsenide (GaAs) contact layer, which also prevents the $Al_{0.55}Ga_{0.45}As$ layer from oxidising. Instead of a 3 µm thick $Al_{0.55}Ga_{0.45}As$ current spreading layer and a 10 nm thick GaAs contact layer, a few µm thick gallium phosphide (GaP) layer can be used. Such a GaP layer does not oxidise, is transparent for the wavelength under consideration and can be highly doped. A thick current spreading layer as described in this document has the disadvantage that it is penalising the mirror properties of the top DBR mirror, because no use can be made of a high difference in refractive index between the top DBR mirror / air interface. Nevertheless a thick current spreading layer is typically used, because the thicker the layer, the lower its resistance and thus the better the current spreading that can be obtained.

A conventional RCLED has several advantages, such as emitting light perpendicular to the surface of the die, a highly directional beam and the possibility of fabrication of two-dimensional arrays. They do not require complex and expensive processing.

However, while conventional RCLEDs have several advantages, they also have several disadvantages with regard to emission in the visible spectrum, which disadvantages are primarily due to oxidation problems of the $Al_xGa_{1-x}As$ spreading layer, and absorption of the emitted light by the GaAs contact layer. The conventional RCLEDs furthermore have disadvantages in that the GaAs contact layer needs to be highly doped in order to provide a better contact. Such high doping can be achieved at growth temperatures around 550°C - 600°C. However, at these temperatures, the quality of the GaAs contact layer rapidly degrades.

Thus, there is a need for developing visible light emitting diodes, especially resonant cavity light emitting diodes (RCLEDs) for use in high brightness LED applications such as car tail and brake lights, 2-D array for printers and POF (plastic optical fibre) communication at 650 nm, that include a highly doped contact layer, thereby maintaining structural integrity of the light emitting diode device.

US-5923696 describes a VCSEL with an active region between a bottom DBR and a top DBR. A one-half wavelength contact layer including a gallium phosphide material is disposed on top of the top DBR.

It is a purpose of the present invention to provide a new and improved resonant cavity device, especially a resonant cavity light emitting diode that is capable of emission in the visible spectrum, or a resonant detector, and that overcomes the drawbacks mentioned above.

## Summary of the invention

The above objectives are accomplished by a device and a method according to the present invention.

According to a first embodiment of the present invention, a Distributed Bragg Reflector (DBR) is provided for reflecting radiation with a wavelength $\lambda$, including at least one mirror pair, each mirror pair comprising a bottom layer and a top layer, the top layer of one mirror pair comprising gallium phosphide (GaP) and having an optical thickness of substantially an odd multiple of $\lambda/4$. Usually, the top layer consists essentially of gallium phosphide. In addition to GaP the layer may be doped, e.g. with magnesium, beryllium or zinc. The optical thickness of a layer of a DBR is the physical thickness of that layer multiplied by its refractive index.

According to a second embodiment of the present invention, a new and improved resonant cavity device for emitting or absorbing light is provided that utilises a gallium phosphide (GaP) layer as part of a DBR and at the same time as a contact layer. The structure may be capable of being easily p-type doped with a material such as magnesium or zinc without damage to the underlying layer structures.

The resonant cavity device for emitting or absorbing light with a wavelength $\lambda$, according to the present invention, comprises a first mirror and a second mirror with an active region located therebetween, the second mirror comprising a stack of Distributed Bragg Reflectors (DBR) including at least one mirror pair, the mirror pair having at least a top layer and a bottom layer, the top layer being most remote from the first mirror, the top layer being composed of gallium phosphide (GaP) and having an optical thickness of substantially $\lambda/4$ or substantially an odd multiple of $\lambda/4$. The optical thickness of a layer of a DBR is the physical thickness of that layer multiplied by its refractive index.

The optical thickness of the GaP layer in the present invention is of importance, as the GaP layer is part of the second DBR mirror, and thus will contribute to the reflectivity of that mirror.

The device may be e.g. an RCLED. The light emitted by the RCLED preferably has a wavelength $\lambda$ between 590 and 700 nm, and more preferably between 630 and 670 nm, which is red light. Emitting shorter wavelengths is also possible, but more difficult, because the range of compositions that can be used for the DBR is limited.

The substantially $\lambda/4$ or substantially odd multiple of $\lambda/4$ thickness of the GaP layer may include a deviation of at most 15 % from that thickness which is an exact odd multiple of $\lambda/4$, preferably a deviation between 0% and 10% and most preferably a deviation of less than 1%. For an RCLED, the first mirror has a high reflectivity (more than 90%, preferably more than 95%), while the second mirror has a lower reflectivity (between 43% and 90%, preferably between 50% and 70%). The reflectivity of the second mirror may be optimised for maximum efficiency of the RCLED. An advantage of an RCLED, compared to a conventional LED, is that more light can be extracted out of an RCLED, due to the presence of the mirrors, which make light to constructively interfere. For a laser, both the first mirror and the second mirror need to have a reflectivity of greater than 99%.

A resonant cavity device according to the present invention may furthermore comprise a supporting substrate on which the first mirror is disposed. Such a supporting substrate may comprise semiconductor material, for example including GaAs or Ge. Alternatively, the resonant cavity device can be grown on a GaAs or Ge substrate, after which this substrate is removed and the device is transferred onto another substrate.

The first mirror may comprise a metal film located over a phase matching layer, or a stack of DBR including pairs of alternating layers. Said alternating layers are preferably based on n-type doped AlGaAs and/or InAlGaP. There are preferably from one to fifty pairs of layers in the DBR, more preferably more than 10 pairs, and most preferrably more than 20 pairs. The n-type doping is preferably of the order of 1e18 cm$^{-3}$.

The layers of the first mirror have a substantially $\lambda/4$ or a substantially odd multiple of $\lambda/4$ thickness. This thickness of the layers may include a deviation of at most 15 % from that thickness which is an exact odd multiple of $\lambda/4$, preferably a deviation between 0% and 10% and most preferably a deviation between 2% and 3%. Such a deviation in thickness from $\lambda/4$ leads to a detuned DBR, which has some advantages, as will be shown later.

The cavity of the resonant cavity device preferably comprises InAlGaP or AlGaAs material. The active region in the cavity comprises one or a plurality of quantum well layers or a bulk active layer.

The second mirror may include more than one mirror pair, whereby all layers except the top layer comprise AlGaAs. The top mirror should preferably not comprise InAlGaP, because p-doped InAlGaP is highly resistive. The second mirror is preferably p-type doped with a doping level of the order of 1e18 cm$^{-3}$ to 2e18 cm$^{-3}$, except for the top GaP layer which is preferably more highly doped: e.g. a p-doping level higher than 5e18 cm$^{-3}$, such as 3e19 cm$^{-3}$. This top GaP layer with a higher doping level allows a better ohmic contact. Only the top part of the GaP layer needs to be highly doped. The GaP top layer may be doped e.g. with Magnesium, Zinc and/or Beryllium.

The present invention also provides a method of manufacturing a resonant cavity device for emitting or absorbing light with a wavelength $\lambda$, comprising the steps of:

- providing a supporting substrate having a surface,
- forming a first mirror on the surface of the supporting substrate,

- forming a second mirror with an active region located between the first and second mirrors, the second mirror comprising a stack of Distributed Bragg Reflectors (DBR) including at least one mirror pair, the mirror pair comprising at least a top and a bottom layer, the top layer, being most remote from the first mirror, being composed of GaP and having an optical thickness of substantially $\lambda/4$ or substantially an odd multiple of $\lambda/4$. The optical thickness of a layer of a DBR is the physical thickness of that layer multiplied by its refractive index.

The step of forming a first mirror preferably includes growing a stack of DBR including pairs of alternating layers on the semiconductor substrate. The layers of the first mirror have a substantially $\lambda/4$ or a substantially odd multiple of $\lambda/4$ thickness. This thickness of the layers may include a deviation of at most 15 % from that thickness which is an exact odd multiple of $\lambda/4$, preferably a deviation between 0% and 10% and most preferably a deviation between 2% and 3%.

It is possible to form a resonant cavity device comprising a first mirror, an active region, a second mirror and a GaP top layer on a first substrate such as e. g. GaAs or Ge, separate the resonant cavity device from the first substrate, and thereafter transfer it to a second substrate such as e.g. GaP.

Alternatively, the present invention also provides a method of manufacturing a resonant cavity light-emitting device for emitting light with a wavelength $\lambda$, comprising the steps of:

- providing a supporting substrate having a surface,
- forming a second mirror with an active region located between the supporting substrate and the second mirror, the second mirror comprising a stack of Distributed Bragg Reflectors including at least one mirror pair, the mirror pair comprising a top and a bottom layer, the top layer, being most remote from the supporting substrate, being composed of GaP and having an optical thickness of substantially $\lambda/4$ or substantially an odd multiple of $\lambda/4$,
- separating the active region and the second mirror from the supporting substrate, and
- transferring the active region and the second mirror onto a device having a first mirror.
  The active region may be part of a cavity. The cavity may e.g. be disposed on an intermediate layer disposed on the supporting substrate, such intermediate layer being an etch stop layer. This etch stop layer can then be etched away for separating the cavity and second mirror from the substrate.

The step of providing a supporting substrate in both methods preferably includes providing a semiconductor substrate, such as e.g. a GaAs or Ge substrate.
The step of forming a second mirror comprising a stack of Distributed Bragg Reflectors with a top layer composed of GaP having an optical thickness of substantially $\lambda/4$ or substantially an odd multiple of $\lambda/4$ in both methods includes providing a top layer with a deviation of at most 15 % from that optical thickness of $\lambda/4$. The optical thickness of a layer of a DBR is the physical thickness of that layer multiplied by its refractive index.
A device made according to the first method can be a semiconductor resonant cavity device with two DBR mirrors, while a device made according to the second method can be a semiconductor resonant cavity device with a metal mirror as first mirror, and a DBR mirror as second mirror.
A novel device and a method for making the device are disclosed. A light emitting or absorbing device now can be fabricated to include a doped contact layer, in which the device structure is not degraded during the fabrication process. The light emitting or absorbing device can generate or absorb light in the visible spectrum. Additionally, since the fabrication of the contact layer is integrated in the process flow of the light emitting device, the light emitting device is more easily manufactured, thus reducing overall costs and allowing significant improvements in reliability and quality.
Other features and advantages of the present invention will become apparent from the following detailed description, taken in conjunction with the accompanying drawings, which illustrate, by way of example, the principles of the invention.
The reference figures quoted below refer to the attached drawings.

**Brief description of the drawings**

Fig. 1 shows an enlarged detail of a DBR mirror.
Fig. 2 is a graph of reflectivity R of a DBR in function of wavelength $\lambda$ at normal incidence, for 26 $Al_{0.55}Ga_{0.45}As$/AlAs mirror pairs.
Fig. 3 is a graph of refractive index of AlGaAs in function of the aluminum content in the AlGaAs material, at a wavelength of 640 nm.
Fig. 4 is a graph of reflectivity R of a DBR in function of the incidence angle of the light; the critical angle $\theta_c$ below which light can be extracted being indicated.
Fig. 5 illustrates an RCLED according to an embodiment of the present invention.
Fig. 6 illustrates the principle of a critical angle for outcoupling light.
Fig. 7 is a graph showing the reflectivity of a DBR mirror in function of the number of $Al_{0.55}Ga_{0.45}As$/AlAs DBR mirror pairs at 640 nm.

In the different figures, the same reference figures refer to the same or analogous elements.

## Description of the illustrative embodiments

The present invention will be described with respect to particular embodiments and with reference to certain drawings but the invention is not limited thereto but only by the claims. In particular the invention is not limited to the materials mentioned in the description; other suitable materials may also be used. The drawings described are only schematic and are non-limiting. In particular supplementary layers, not shown in the drawings nor explicitly mentioned in the description, may be added without departing from the scope of the invention. In particular, although the present invention will mainly be described with reference to RCLED's it may be applied to other devices e.g. to a laser such as a light emitting vertical cavity surface emitting laser or to a resonant detector in which incoming light is converted into a current the inverse way as for driving e.g. an RCLED.

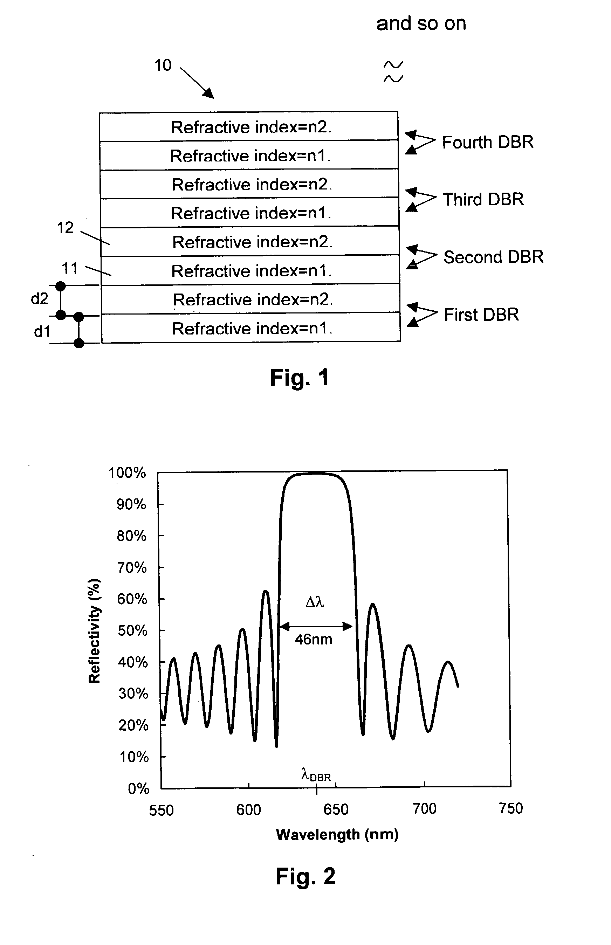

Fig. 1 shows part of a DBR mirror 10. A DBR mirror 10 consists of a periodic stack of alternating high and low refractive index materials layers 11, 12, e.g. gallium arsenide (GaAs) and aluminium arsenide (AlAs). The difference in the refractive indexes n1 and n2 from the layers 11 and 12 respectively, is responsible for reflection of the DBR mirror 10.

Layers 11 have a physical thickness $d_1$ and a refractive index $n_1$, and layers 12 have a physical thickness $d_2$ and a refractive index $n_2$. The physical thickness $d_1$, $d_2$ of each layer 11, 12 is chosen for quarter-wavelength reflection at a given wavelength $\lambda$ as follows:

$$d_1 = \lambda/4n_1 \ *cte$$

$$d_2 = \lambda/4n_2 \ *cte$$

with cte an odd integer.

If the optical thickness, i.e. $d_i n_i$ is optimised, i. e. as close as possible to an odd multiple of $\lambda/4$, constructive interference applies. When a DBR 10 is being made, and e.g. a layer 12 is deposited on top of a layer 11, its physical thickness $d_2$ has to be accurately controlled.

A quarter wave thickness of each layer, i.e. an optical thickness equal to an odd multiple of $\lambda/4$, ensures that the reflection is constructive. This quarter wave thickness may be any odd multiple (1, 3, 5, etc) of the optical thickness.

For example, a DBR mirror pair 11, 12 consisting of AlGaAs (with refractive index n1 = 3.46) and AlAs (with refractive index n2 = 3.1) is considered at 640 nm. The quarter wave thickness for AlGaAs is 640/(4*3.46) = 46.3 nm or any odd multiple thereof. Similarly, for AlAs, the quarter wave thickness will be 640/(4*3.1) = 51.6 nm or any odd multiple thereof.

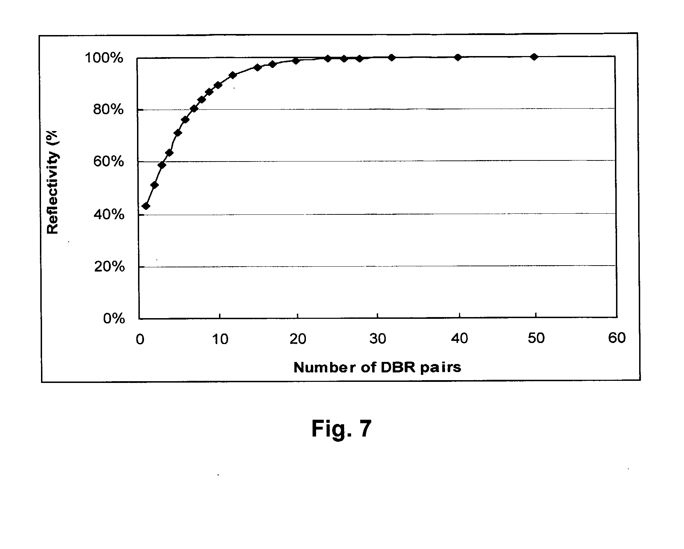

As shown in Fig. 1, DBR mirror pairs 11, 12 can be stacked together to have increased reflectivity, as shown in Fig. 7.

Going back to a basic example of one quarter wave thickness, one quarter wave thickness of AlGaAs and one quarter wave thickness of AlAs is needed to make one mirror pair. The total thickness for one mirror pair is then a half wavelength thickness. A half wavelength thickness material has no mirror properties and will only act as a transparent medium for light to pass through.

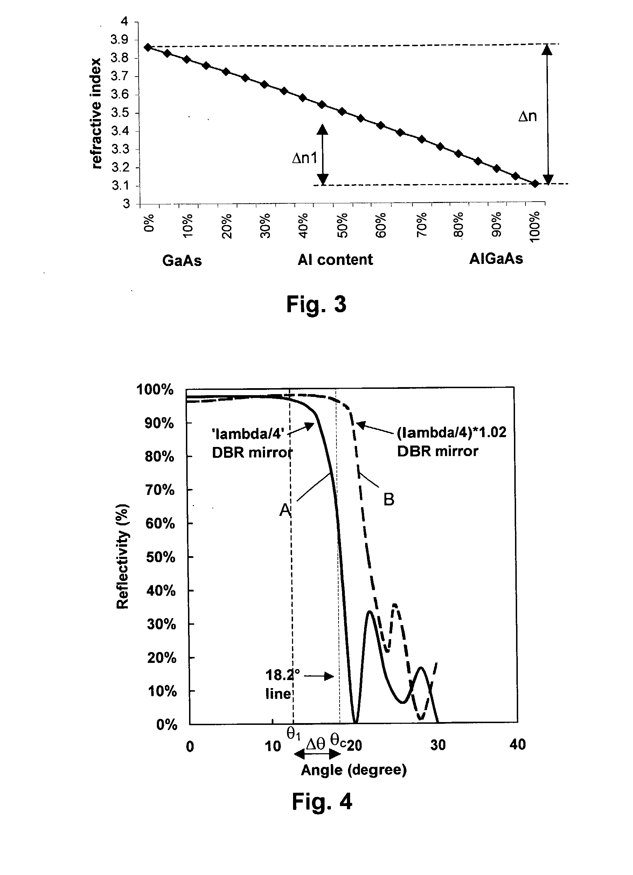

The reflectivity of a DBR 10 is a complex function of the incidence angle of the light on the DBR 10 and the wavelength of the light. The DBR mirror 10 can be highly reflective, but only over a limited wavelength and incidence angle range, as shown in Fig. 2 and Fig. 4.

Fig. 2 shows the reflectivity R of a DBR mirror 10 composed of 26 pairs of alternating aluminium arsenide (AlAs) and aluminium gallium arsenide ($Al_{0.55}Ga_{0.45}As$) layers 11, 12, in function of the wavelength $\lambda$. Thicknesses were 51.6 nm and 46.3 nm respectively for AlAs (n=3.1 at 640 nm) and $Al_{0.55}Ga_{0.45}s$ (n=3.46 at 640 nm) for an exact quarter wave thickness DBR mirror. $\lambda_{DBR}$ is the central wavelength for which the DBR mirror 10 is designed to have the highest reflection, in the present case $\lambda_{DBR}$ = 640 nm, and at this central wavelength the DBR has a reflectivity of 99.43%. It can be seen from Fig. 2 that the DBR 10 has a high reflection for a limited wavelength range $\Delta\lambda$. Depending on the material composition of the DBR mirror, $\Delta\lambda$ typically is between 30 nm and 60nm, 46 nm for the specific example given in Fig. 2.

It is to be noted that bandwidth and reflectivity of a DBR mirror change with different DBR mirror materials. The reflectivity R is higher when the difference $\Delta n$ in refractive indexes of the layers 11, 12 is bigger. Fig. 3 shows the refractive index of AlGaAs in function of the content of aluminium in it, at a wavelength of 640 nm. The more aluminium it contains, the lower the refractive index for a certain wavelength. For a DBR mirror 10, AlGaAs with aluminium content between 0% and 55% is preferably not used, because then AlGaAs becomes absorbing for wavelengths below 640 nm. If a DBR 10 would be made with $Al_{x1}Ga_{1-x1}As / Al_{x2}Ga_{1-x2}As$ (x1, x2 between 55% and 100%), then the reflectivity R would be maximum for a certain wavelength for an aluminium content of 55% for one type of layers 11 and 100% for the other type of layers 12. If $\Delta n$ is smaller, then $\Delta\lambda$ (Fig. 2) and R also become smaller for the same number of DBR mirror pairs, i.e. the DBR mirror 10 is reflective for a smaller range of wavelengths around the central wavelength $\lambda_{DBR}$.

Fig. 4 is a graph of the reflectivity R of a DBR mirror 10 in function of the incidence angle $\theta$ of the light on the DBR mirror 10. Fig. 4 shows reflection of a 26 period ($Al_{0.55}Ga_{0.45}As/AlAs$) DBR. Taking into account an average refractive index of 3.2 for the semiconductor device, the critical angle into air is $(\sin^{-1} 1/3.2)=18.2°$. Fig. 4 shows the line that corresponds to 18.2° as a reference.

In principle, for a perfectly tuned DBR mirror 10 (i.e. a DBR mirror of which the alternating layers have an optical thickness of exactly an odd multiple of $\lambda/4$ - for the example given in Fig. 4: 46.3 nm layers for $Al_{0.55}Ga_{0.45}As$, which has a refractive index n=3.46 at 640 nm; and 51.6 nm layers for AlAs, which has a refractive index n=3.1 at 640 nm), light rays could be extracted for an incidence angle between $0°$ and $\theta_c$, $\theta_c$ being the critical angle. However, for a range $\Delta\theta$ of incidence angles between $\theta_1$ and $\theta_c$, the reflectivity R of the DBR mirror 10 is not as high, as shown by graph A in Fig. 4, so that not all the light which is extracted is reflected to the same amount.

The reflectivity of a DBR mirror 10 increases as a function of the number of DBR pairs 11, 12, as can be seen in Fig. 7. One pair of DBR mirrors provides 43% reflection. Initially, reflectivity increases linearly with the number of DBR periods, then the rate of increase reduces for beyond 12 pairs, and afterwards, reflectivity increases very slowly. For 50 mirror pairs, the reflectivity of a DBR mirror is 99.92%.

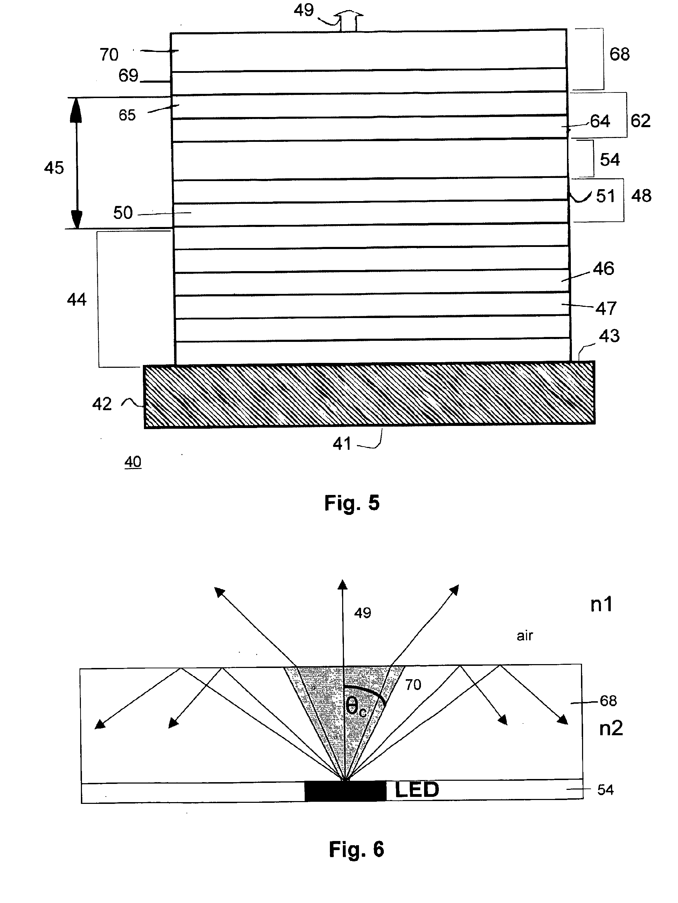

Fig. 5 illustrates an enlarged cross-sectional view of an RCLED 40 according to the present invention. The RCLED is formed on a supporting substrate 42 having surfaces 41 and 43. Light 49 is emitted by the RCLED in a direction perpendicular to the substrate 42. This light 49 has a wavelength $\lambda$.

Substrate 42 is made of any suitable material, such as a semiconductor material. Typically, substrate 42 is made of gallium arsenide (GaAs) or germanium (Ge). Ge has a slightly higher lattice constant as GaAs, but both lattices are close enough to each other to make Ge a valuable candidate to replace GaAs. Ge is much cheaper and is mechanically stronger than GaAs, and there is currently a shortage of GaAs substrates because of the increased demand, while Ge has a more elastic supply.

An RCLED 40 contains a highly reflective (R = 90%-99.9%) bottom mirror 44 and an only moderate reflective (R = 50%-90%) top mirror 68, in between which mirrors 44, 68 an active region 54 is disposed between spacers 48, 62.

The bottom mirror 44 may e.g. be a first stack of Distributed Bragg Reflectors (DBR) having a plurality of alternating layers made of two different materials with alternating refractive indexes, illustrated by layers 46 and 47, e.g. 26 pairs of alternating layers (only a few layers are represented in Fig. 5).

The bottom mirror 44 may e.g. be made of layers of GaAs, AlGaAs, InAlGaP, or combinations of these, the layers being n-doped. In fact, any material that is lattice matched to the substrate material (GaAs or Ge) and which can be sufficiently doped (order of $10^{18}$ $cm^{-3}$) can be used. Any suitable n-type dopants, such as silicon, selenium, sulphur or the like may be used for doping the DBR bottom mirror 44. The doping is necessary in order to obtain good current spreading and conduction in the RCLED device 40.

Examples of combinations of layers 46 and 47 may be:

1. $Al_{x1}Ga_{1-x1}As$ / $Al_{x2}Ga_{1-x2}As$, with 0 < x1, x2 < 100% and x1 ≠ x2;
2. $In(Al_{x1}Ga_{1-x1})P$ / $In(Al_{x2}Ga_{1-x2})P$, with x1, x2 between 100% and 0%, x1 ≠ x2;
3. $Al_{x1}Ga_{1-x1}As$ / $In(Al_{x2}Ga_{1-x2})P$, with x1 > 95%, x2 between 100% and 0%;

or combinations of 1 to 3.

It should be understood that in the examples contained within this description where a percent composition of a particular element is given it should be considered only as an example. It should be further understood that variations from these examples can be large and are part of the present invention.

The layers 46, 47 of the bottom mirror 44 have an optical thickness of substantially an odd multiple of one quarter wavelength. Alternatively, the bottom mirror 44 can be detuned.

Generally, the plurality of alternating layers 46, 47 of DBR bottom mirror 44 are from one pair to fifty mirror pairs, with a preferred number of mirror pairs ranging from twenty two to thirty three mirror pairs. However, it should be understood that the number of mirror pairs could be adjusted for specific applications.

The top mirror 68 may e.g. be a second stack of DBR including at least one mirror pair 69, 70, the top layer 70 of which is composed of gallium phosphide (GaP) and has an optical thickness of substantially an odd multiple of one quarter wavelength. In Fig. 5, an embodiment is shown with only one mirror pair in the top mirror 68, comprising a layer 69 of e.g. $Al_xGa_{1-x}As$, with x > 95% (e.g. $Al_{0.97}Ga_{0.3}As$) and a top layer 70 of GaP. The alternating layers 69 and 70 are formed such that alternating layers 69 and 70 differ in their refractive indexes.

If more than one mirror pair is used in the top mirror 68, only the top mirror pair 69, 70 is as described hereinabove; the other mirror pairs (not represented in Fig. 5, but, if present, disposed between the top mirror pair 69, 70 and cladding region 62) have a plurality of alternating layers made of two different materials with alternating refractive indexes, the layers being p-doped. Such alternating layers may e.g. be made of $Al_{0.55}Ga_{0.45}As$ and $Al_xGa_{1-x}As$, with x > 95% (e.g. $Al_{0.97}Ga_{0.03}As$). Any suitable p-type dopants, such as magnesium, zinc, carbon, beryllium or the like can be used to dope DBR top mirror 68.

The layers of the top mirror 68 have an optical thickness of substantially an odd multiple of one quarter wavelength. This means that, if RCLED 40 is designed to emit light with a wavelength of 640 nm (bright red), and a top mirror 68 with a first layer 69 of $Al_{0.97}Ga_{0.3}As$ (optical thickness $\lambda/4$) and a top layer of GaP (optical thickness $3\lambda/4$) is used, these layers have a thickness of respectively substantially 51.6 nm and substantially 141 nm.

It is not possible to have, in the top mirror 68, a plurality of layers being a combination of e.g. $Al_{0.97}Ga_{0.03}As$ and GaP layers, because GaP is not lattice matched to GaAs, and therefore it can only be used as a top layer 70. If it were to be used as an intermediate layer, dislocations would appear in layers subsequently grown on top of the GaP layer. It has been found, however, that a GaP layer can be grown with a good quality on top of an (Al)GaAs layer.

In between the bottom mirror 44 and the top mirror 68, a cavity 45 with an active region 54 is provided. In the active region 54, injected electrons and holes recombine and emit photons. The active region 54 may be a quantum well structure (one or a plurality of quantum wells embedded in barrier layers) or a bulk active layer.

According to one embodiment of the present invention, active region 54 is a quantum well layer made of e.g. undoped $(Al_{0.1}Ga_{0.9})_{0.43}In_{0.57}P$ , with barrier layers being made of undoped $(Al_{0.7}Ga_{0.3})_{0.52}In_{0.48}P$, thereby causing RCLED 40 to emit light (arrow 49) in the visible spectrum.

Some material is needed to fill the cavity 45, and this material is given by a plurality of cladding regions 48, 62. In Fig. 5, cladding region 48 comprises layers 50 and 51, and cladding region 62 comprises layers 64 and 65. Layer 50 of cladding region 48, in close contact with bottom mirror 44, is n-type doped like bottom mirror 44, and layer 65 of cladding region 62, in close contact with top mirror 68, is p-type doped like top mirror 68. Layers 51 and 64 of cladding regions 48 and 62, respectively, and active region 54 is generally undoped.

Generally, cavity 45, comprising cladding regions 48 and 62 and active region 54, provides a thickness that is a slightly larger thickness than a multiple wavelength of light (arrow 49) emitted from RCLED 40. However, the thickness of cladding regions 48 and 62 and active region 54 can be any suitable integer multiple of the wavelength of emitted light.

It should be understood that active region 54 is positioned at an antinode position of the cavity 45, which is a position where maximum resonance of the light is obtained.

It is said above that the layers of the first DBR mirror 44 have an optical thickness of substantially an odd multiple of λ/4. An optical thickness of an odd multiple of λ/4 leads to a tuned DBR. With "substantially" is meant that a detuned DBR may be used, which may have deviations from that optical thickness of at most 15%, preferably between 0% and 10 % and most preferred between 2% and 3%. This means that the optical thickness of layers of the mirrors 44 are not exactly matched to an odd multiple of λ/4. An advantage thereof is that a higher output angle is covered. This is explained with respect to Figs. 4 and 6. An active region 54 where spontaneous emission takes place, is placed between a highly reflective bottom mirror 44 and a moderately reflective top mirror 68 (for an RCLED). Light 49 is only extracted from the RCLED 40 if it falls within a critical angle $\theta_c$, which is dependent on the relation between the refractive indexes of the top layer of the DBR mirror and air. If a detuned DBR is used, the spontaneous emission is reshaped, so that a higher reflectivity is obtained within the critical angle $\theta_c$.

By detuning the first DBR 44, the range of incidence angles for which the DBR is highly reflective is increased. Graph B in Fig. 4 shows a detuned DBR with a detuning of 2%, whereby the thicknesses of the layers are 1.02*46.3 = 47.2 nm for $Al_{0.55}Ga_{0.45}As$ and 1.02*51.6 = 52.6 nm for AlAs. It can be seen from Fig. 4 that for the exactly tuned DBR, reflectivity falls to below 60% at an incidence angle of 18.2°. This implies that a substantial amount of light is lost at this critical angle region. When detuning of the DBR is done by adding only 2% extra thickness to each of the DBR mirrors, the reflectivity goes up to more than 97% at the angle of 18.2°, implying that most of the light is now reflected within the acceptance angle.

It may be noted from Fig. 4 that a detuned DBR mirror (graph B) has a slightly lower reflectivity at 0° angle compared to the exact DBR (graph A). The higher the detuning, the lower the reflectivity at the 0° angle will be. To compensate for this effect, a larger number of DBR mirror pairs might be needed to match exact DBR reflectivity at 0° angle.

Furthermore, once a DBR is detuned, the resulting RCLED using such a detuned DBR as first mirror is less dependent on temperature. The detuned DBR can compensate for the variation of resonance matching of the microcavity with changing temperature.

The temperature coefficient of the emission wavelength is about 0.33 nm/K for GaAs and InGaAs based active regions, 0.32 nm/K for InAlGaP based quantum well structures. For an AlGaAs based DBR, the temperature coefficient is about 0.087 nm/K.

An RCLED 40 structure may be e.g. epitaxially grown by MOCVD (metal organic vapour deposition), by MBE (molecular beam epitaxy) , or in any other way known to a person skilled in the art. These methods allow for the epitaxial deposition of material layers, such as InAlGaP, InGaP, GaP, AlAs, AlGaAs, InAlP and the like. DBR bottom mirror 44 is epitaxially deposited on surface 43 of substrate 42. As shown in Fig. 5, cladding region 48 is typically made of two components (it may be made of one or more components) that are epitaxially disposed or deposited on DBR bottom mirror 44. First, layer 50, made of any suitable material, such as InAlGaP, InAlP, or the like, is epitaxially deposited on bottom mirror 44. Layer 50 is n-type doped with any suitable dopant such as silicon, selenium, sulphur or the like, similar to stack 44. Second, layer 51, made of any suitable material, such as InAlGaP, or the like, having an appropriate thickness and typically being undoped (because an undoped layer 51 protects the active region from unwanted contamination by doping in layer 50), is epitaxially deposited on layer 50. The thickness of cavity 45 is determined by the wavelength of light (arrow 49) that is to be emitted from RCLED 40. Active region 54, as shown in Fig. 5, is represented by a single layer which is epitaxially deposited or disposed on cladding region 48; however, active region 54 is more clearly defined as including a plurality of layers. More specifically, active region 54 may include a quantum well structure (quantum well layers embedded in barrier layers) or a bulk active layer. The active region 54 is positioned such that it is located at an antinode position of the cavity 45. Cladding region 62 typically includes two layers, such as layers 64 and 65 (but may comprise one or more layers) that are disposed or deposited epitaxially on active region 54. First, layers 64 and 65 are made of any suitable cladding material, with reference to cladding region 62, that is epitaxially deposited to an appropriate thickness. By way of example, layer 64 may be formed of undoped $In_{0.49}(Al_xGa_{1-x})_{0.51}P$ that is epitaxially deposited on active region 54. Subsequently, layer 65 is e.g. formed of doped $In_{0.49}(Al_xGa_{1-x})_{0.51}P$ that is epitaxially deposited on undoped layer 64. Doping for layer 65 is with a p-type dopant. Subsequent depositions define DBR top mirror 68 with a p-doped GaP top layer 70. The GaP top layer 70 serves as part of the DBR top mirror 68, as contact region and as transparent window for the emitted radiation. GaP is a wide band-gap material, that is transparent to the wavelength of this particular embodiment. GaP is easily doped with a p-type dopant, such as magnesium, zinc, beryllium, or a combination of these dopants, to a level of 3e19 $cm^{-3}$ or higher. In addition, GaP is not degraded by the high temperatures which doping steps typically require, such as 700°C, and is capable of serving as a good passivation layer.

The various steps of the method disclosed have been performed in a specific order for purposes of explanation. However, it should be understood that various steps of the disclosed method may be interchanged and/or combined with other steps in specific applications and it is fully intended that all such changes in the disclosed methods come within the scope of the claims.

For example, the RCLED structure may be grown on a GaAs substrate, after which the RCLED structure is removed from the GaAs substrate and transferred onto another substrate, such as e.g. glass or a GaP substrate for example.

As another example, in a first step an etch stop layer may be grown on a substrate. On top of this etch stop layer, an active material is grown, and on top thereof, a top DBR mirror with GaP top layer is grown. Thereafter, an etching solution may be used to remove the etch stop layer, so as to separate the substrate from the active material and top DBR mirror. This active material and top DBR mirror can then be placed on a suitable metal mirror (normally gold), which forms the bottom mirror. Of course this manufacturing process is more complicated and increases the cost of the device.

Surface 43 of substrate 42 can be used to form a bottom contact (not shown) which is electrically coupled to bottom mirror 44. The contact is typically formed by applying any suitable conductive material, such as a metal or an alloy, e.g. gold, silver, platinum, germanium gold alloy, or the like to surface 43, or in some applications to surface 41, and annealing the conductive material with substrate 42. Also other methods can be used to electrically couple DBR 44, such as directly coupling to DBR 44. The alternative methods can be achieved by combining several processing steps, such as photolithography, etching, and metallisation, or the like. Top layer 70 forms a top contact.

When a voltage is applied between the bottom contact and the top contact, spontaneous emission takes place in the active region 54. By spontaneous emission, a same amount of light is emitted in all directions. This emitted light bounces between the bottom mirror 44 and the top mirror 68, and if the thickness of the layers in the bottom mirror 44 and the top mirror 68 is an odd multiple of $\lambda/4$, and if the thickness of the cavity is slightly larger than a multiple of the wavelength of the emitted light, constructive interference takes place. As the top mirror 68 is less reflective than the bottom mirror 44, light will be emitted through the top mirror 68, out of the RCLED 40, according to arrow 49 in Fig. 5.

While the invention has been shown and described with reference to preferred embodiments, it will be understood by those skilled in the art that various changes or modifications in form and detail may be made without departing from the scope and spirit of this invention.

For example, while Fig. 5 only illustrates a portion of a single RCLED 40, a plurality of RCLEDs may be located on a same substrate 42 to form an array of RCLEDs.

Furthermore, it should be understood that Fig. 5 is a simplified illustration and that many elements have been purposely omitted to illustrate more clearly the present invention.

Additionally, it should be understood that RCLED 40 can be formed by any suitable method to shape emitted light (arrow 49) into a variety of geometric patterns, such as a square, a circle, a triangle, or the like.

**Claims**

1. A Distributed Bragg Reflector (68) for reflecting radiation with a wavelength $\lambda$, including at least one mirror pair (69, 70), each mirror pair comprising a bottom layer and a top layer, the top layer (70) of one mirror pair consisting essentially of GaP and having an optical thickness of substantially $\lambda/4$ or substantially an odd multiple of $\lambda/4$.

2. A resonant cavity device (40) for emitting or absorbing light with a wavelength λ, comprising:

- a first mirror (44) and a second mirror (68) with an active region located therebetween,
- the second mirror (68) comprising a stack of Distributed Bragg Reflectors including at least one mirror pair (69, 70), the mirror pair comprising at least a top and a bottom layer, the top layer, being most remote from the first mirror, being composed of GaP and having an optical thickness of substantially λ/4 or substantially an odd multiple of λ/4.

3. A resonant cavity device (40) according to claim 2, wherein the optical thickness of the GaP layer of substantially λ/4 or substantially an odd multiple of λ/4 includes a deviation of at most 15 % from that thickness of λ/4, preferably between 0% and 10%, more preferred between 0% and 5%, and most preferred 0%.

4. A resonant cavity device (40) according to any of claims 2 or 3, wherein the first mirror (44) comprises a stack of Distributed Bragg Reflectors including pairs of alternating layers (46, 47).

5. A resonant cavity device (40) according to claim 4, wherein the optical thickness of the layers of the first mirror comprising the stack of Distributed Bragg Reflectors includes a deviation from substantially λ/4 or substantially an odd multiple of λ/4 by at most 15 % , preferably between 0% and 10% and most preferred between 2% and 3%.

6. A resonant cavity device (40) according to any of claims 4 or 5, wherein the alternating layers (46, 47) in the first mirror (44) are based on n-type doped AlGaAs and/or InAlGaP.

7. A resonant cavity device (40) according to any of claims 3 to 6, wherein the pairs of alternating layers (46, 47) in the first mirror (44) comprises one to fifty pairs of layers.

8. A resonant cavity device (40) according to any of claims 2 or 3, wherein the first mirror comprises a metal film.

9. A resonant cavity device (40) according to any of claims 2 to 8, wherein the cavity (45) comprises InAlGaP of AlGaAs material.

10. A resonant cavity device (40) according to any of claims 2 to 9, wherein the active region (54) comprises a quantum well structure or a bulk active layer.

11. A resonant cavity device (40) according to any of claims 2 to 10, furthermore comprising a supporting substrate (42) on which the first mirror (44) is disposed.

12. A resonant cavity device (40) according to claim 11, wherein the supporting substrate (42) comprises semiconductor material.

13. A resonant cavity device according to claim 12, wherein the semiconductor material includes GaAs or Ge or GaP.

14. A resonant cavity device (40) according to any of claims 2 to 13, wherein the second mirror (68) includes more than one mirror pair, whereby all layers (69) except the top layer (70) comprise AlGaAs.

15. A resonant cavity device (40) according to any of claims 2 to 14, wherein the GaP top layer (70) is doped with Magnesium and/or Zinc and/or Beryllium.

16. A method of manufacturing a resonant cavity device (40) for emitting or absorbing light with a wavelength λ, comprising the steps of:

- providing a supporting substrate (42) having a surface (43),
- forming a first mirror (44) on the surface (43) of the supporting substrate (42),
- forming a second mirror (68) with an active region (54) between the first and second mirrors, the second mirror (68) comprising a stack of Distributed Bragg Reflectors including at least one mirror pair (69, 70), the mirror pair comprising a top and a bottom layer, the top layer (70) being most remote from the first mirror, being essentially composed of GaP and having an optical thickness of substantially λ/4 or substantially an odd multiple of λ/4.

17. A method of manufacturing a resonant cavity device (40) for emitting or absorbing light with a wavelength λ, comprising the steps of:

- providing a supporting substrate (42),
- forming a second mirror (68) with an active region between the second mirror and the substrate, the second mirror comprising a stack of Distributed Bragg Reflectors including at least one mirror pair (69, 70), the mirror pair comprising a top and a bottom layer, the top layer (70), being most remote from the supporting substrate, being essentially composed of GaP and having an optical thickness of substantially λ/4 or substantially λ/4 or substantially λ/4 or substantially an odd multiple of λ/4,
- separating the active region and the second mirror (68) from the substrate,
- transferring the active region and the second mirror (68) onto a device having a first mirror.

18. A method according to any of claims 16 or 17, wherein the step of providing a supporting substrate (42) includes providing a semiconductor substrate.

19. A method according to claim 18, wherein the step of providing a semiconductor substrate includes providing a GaAs, Ge or GaP substrate.

20. A method according to any of claims 16, 18 or 19, wherein the step of forming a first mirror (44) includes growing a stack of Distributed Bragg Reflectors including pairs of alternating layers (46, 47) on the substrate (42).

21. A method according to claim 20, wherein the step of growing the first mirror including a stack of Distributed Bragg Reflectors includes growing layers with an optical thickness which includes a deviation from substantially $\lambda/4$ or substantially an odd multiple of $\lambda/4$ by at most 15 %, preferably between 0% and 10% and most preferred between 2% and 3%.

22. A method according to any of claims 16 to 21, wherein the step of forming a second mirror (68) comprising a stack of Distributed Bragg Reflectors with a top layer (70) essentially composed of GaP having an optical thickness of substantially $\lambda/4$ or substantially an odd multiple of $\lambda/4$ includes providing a top layer with a deviation of at most 15 %, preferably between 0 and 10% and most preferred a deviation of 0% from that optical thickness of $\lambda/4$.

and so on

~
~

10

| Refractive index=n2. |
| Refractive index=n1. |

} Fourth DBR

| Refractive index=n2. |
| Refractive index=n1. |

} Third DBR

12

| Refractive index=n2. |
| Refractive index=n1. |

} Second DBR

11

| Refractive index=n2. |
| Refractive index=n1. |

} First DBR

d2

d1

**Fig. 1**

**Fig. 2**

**Fig. 3**

**Fig. 4**

**Fig. 5**

**Fig. 6**

**Fig. 7**

**European Patent Office**

# EUROPEAN SEARCH REPORT

Application Number

EP 01 20 3678

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 549 167 A (AT&T) 30 June 1993 (1993-06-30) | 1-4,6-8, 10-13, 15,16, 18-20,22 | G02B6/12 H01L33/00 H01S5/183 H01L31/0203 |
| Y | * the whole document * | 17 | |
| Y | EP 0 860 913 A (MOTOROLA INC) 26 August 1998 (1998-08-26) * the whole document * | 17 | |
| X | PICKRELL G ET AL: "Fabrication of GaP/Al-oxide DBRs" APPLIED PHYSICS LETTERS, FEB 2001, vol. 78, pages 1044-1046, XP002190657 ISSN: 0003-6951 | 1-4, 10-13, 16, 18-20,22 | |
| Y | * the whole document * | 6-9,15 | |
| D,Y | US 5 923 696 A (RAMDANI J ET AL) 13 July 1999 (1999-07-13) * the whole document * | 6-9,15 | |
| X | PATENT ABSTRACTS OF JAPAN vol. 1996, no. 03, 29 March 1996 (1996-03-29) & JP 07 302953 A (FURUKAWA ELECTRIC CO), 14 November 1995 (1995-11-14) * abstract * | 1-4,7, 10-13, 16, 18-20,22 | TECHNICAL FIELDS SEARCHED (Int.Cl.7) G02B H01L H01S |
| A | EP 0 880 181 A (HEWLETT PACKARD CO) 25 November 1998 (1998-11-25) * column 6, line 12 - column 10, line 21 * | 1,2,16 | |
| A | GB 2 312 783 A (EPITAXIAL PRODUCTS INT) 5 November 1997 (1997-11-05) * the whole document * | 1,2,16 | |

-/--

The present search report has been drawn up for all claims

| Place of search | Date of completion of the search | Examiner |
|---|---|---|
| THE HAGUE | 18 February 2002 | van der Linden, J.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 01 20 3678

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | MACDOUGAL M ET AL: "Epitaxial (Al,Ga)InP-oxide DBRs" IEEE PHOTONICS TECHNOL LETTERS, 1995, vol. 7, pages 385-387, XP000509424 ISSN: 1041-1135 * the whole document * | 1,2,16 | |

TECHNICAL FIELDS SEARCHED (Int.Cl.7)

The present search report has been drawn up for all claims

| Place of search | Date of completion of the search | Examiner |
|---|---|---|
| THE HAGUE | 18 February 2002 | van der Linden, J.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 01 20 3678

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2002

| Patent document cited in search report | | Publication date | Patent family member(s) | | Publication date |
|---|---|---|---|---|---|
| EP 0549167 | A | 30-06-1993 | US | 5206871 A | 27-04-1993 |
| | | | CA | 2083122 A1 | 28-06-1993 |
| | | | DE | 69209630 D1 | 09-05-1996 |
| | | | DE | 69209630 T2 | 22-08-1996 |
| | | | EP | 0549167 A2 | 30-06-1993 |
| | | | HK | 146096 A | 09-08-1996 |
| | | | JP | 5251819 A | 28-09-1993 |
| | | | KR | 147857 B1 | 02-11-1998 |
| EP 0860913 | A | 26-08-1998 | US | 5835521 A | 10-11-1998 |
| | | | EP | 0860913 A2 | 26-08-1998 |
| | | | JP | 10256656 A | 25-09-1998 |
| | | | TW | 379475 B | 11-01-2000 |
| | | | US | 6121068 A | 19-09-2000 |
| US 5923696 | A | 13-07-1999 | JP | 10215025 A | 11-08-1998 |
| JP 07302953 | A | 14-11-1995 | NONE | | |
| EP 0880181 | A | 25-11-1998 | US | 6100586 A | 08-08-2000 |
| | | | EP | 0880181 A2 | 25-11-1998 |
| | | | JP | 11040887 A | 12-02-1999 |
| GB 2312783 | A | 05-11-1997 | US | 6037603 A | 14-03-2000 |